# EUROPEAN PATENT APPLICATION

(11) **EP 4 794 470 A1**
(43) Date of publication of application: **19.08.2026**
(21) Application number: 25158150.0
(22) Date of filing: 14.02.2025
(51) Int. Cl.: H10D 8/01, H10D 8/25, H10D 62/822

(54) **STRAIN INSENSITIVE ZENER DIODE**

(71) Applicant: NXP B.V., 5656 AG Eindhoven (NL)
(72) Inventor: Mehrotra, Saumitra, Chandler, 85224 AZ (US); Cheng, Xu, Chandler, 85224 AZ (US); Zhu, Ronghua, Chandler AZ, 85224 (US)
(74) Representative: Colaiuda, Antonella

(57) **Abstract**

The disclosure relates to a Zener diode that is insensitive to external stress, and to a method of making such a Zener diode. A lattice mismatch is used to induce a compressive stress in the junction of the Zener diode in the direction of current flow. The lattice mismatch may be produced by carbon doping.

## Description

### Field

The disclosure relates to a Zener diode and a method of making a Zener diode.

### Background

Zener diodes are diodes that are designed to operate in reverse breakdown without being damaged. Zener diodes are designed to have a well-defined breakdown voltage, for example 3.3V, 5.0V, or 5.3V etc.

Precision analog circuitry often requires accurate voltage reference circuits. Zener diodes are typically a critical component of such a circuit, and any change in the breakdown voltage of a Zener diode in a voltage reference may be problematic.

Silicon devices are typically packaged, to allow for handling of the device and to provide suitable electrical connections (e.g. a surface mount package for a printed circuit board). Silicon has a relatively low coefficient of thermal expansion (CTE): around 2.6 microstrain/K at 300K. Packages often comprise materials with higher CTE. For example, die attach adhesive may have a CTE of 1-5 microstrain/K, a PCB substrate (e.g. made from FR4 or another suitable material) may have a CTE of ~4-17 microstrain/K and plastic may have a CTE of 13-20 microstrain/K or more.

This mismatch in CTE results in strain within the junction of the Zener diode as a result of changes in temperature. The breakdown voltage of the junction is sensitive to strain. The result is that the breakdown voltage of a Zener diode can be subject to undesirable fluctuations resulting from changes in temperature, or as a result of strain that is induced in any other way.

Various processes can induce strain in a Zener diode: including packaging and solder reflow. Ageing may relax some of these stresses (e.g. through creep). A variance in breakdown voltage may result that is undesirable.

A stress insensitive Zener diode is desirable.

### Summary

According to a first aspect there is provided a Zener diode comprising: a first region comprising a first dopant:
a second region with a second dopant in contact with the first region, the first region and second region defining a junction of the Zener diode at an interface between the first region and the second region;
wherein:
   i) the first dopant and the second dopant are different types of carrier-providing dopants; and
   ii) the junction comprises a compressive stress in a direction of current flow through the junction resulting from a lattice mismatch between: a) the first region and the second region; or b) the first region and another region of the Zener diode.

The first region and the second region may each comprise a semiconductor. The semiconductor may be silicon, for example, crystalline silicon.

The lattice mismatch may be between crystalline layers of the Zener diode.

The lattice mismatch may be between the first region and the second region. The second region may comprise 0.5 mol% to 2 mol% carbon doping. The first region may have a lattice constant equal to that of intrinsic silicon.

The compressive stress may be between 100 MPa and 250 MPa.

The compressive stress may be between 150 MPa and 200 MPa.

The first region may have a dopant concentration of the first dopant in the range 10¹⁷cm⁻³ to 10¹⁹cm⁻³. The second region may have a dopant concentration of the second dopant in the range 10¹⁸cm⁻³ to 10²¹cm⁻³.

The lattice mismatch may be between the first region and another region of the diode. The first region may comprise a lattice constant equal to that of intrinsic silicon and the other region may comprise silicon germanium.

The first dopant may be n-type and the second dopant p-type. The first dopant may be p-type and the second dopant n-type.

According to a second aspect, there is provided a voltage regulator comprising the Zener diode according to the first aspect, including any optional features thereof.

According to a third aspect, there is provided a method of making a Zener diode, comprising:
implanting a first region of crystalline silicon with a first dopant;
etching a portion of the first region,
depositing a doped crystalline silicon into the etched portion to define a second region and a junction between the first region and the second region;
wherein: the doped crystalline silicon of the second region comprises a second dopant; the first dopant and the second dopant are different types of carrier-providing dopants; and the junction comprises a compressive stress in a direction of current flow through the junction resulting from a lattice mismatch between the first region and the second region.

The second region may comprise between 0.5 mol% and 2 mol% carbon doping.

The compressive stress may be between 100 MPa and 250 MPa.

The compressive stress may be between 150 MPa and 200 MPa.

The first region may have a dopant concentration of the first dopant in the range 10¹⁷cm⁻³ to 10¹⁹cm⁻³ and/or wherein the second region has a dopant concentration of the second dopant in the range 10¹⁸cm⁻³ to 10²¹cm⁻³.

The first dopant may be n-type and the second dopant p-type. The first dopant may be p-type and the second dopant n-type.

The features of the first and second aspect may be applied to the third aspect, including optional features thereof.

According to a fourth aspect there is provided a method of making a Zener diode, comprising:
forming a region of the Zener diode with a first lattice constant;
forming a first region of the Zener diode in contact with the region of the Zener diode having a first lattice constant, wherein the first region has a second lattice constant that is different to the first lattice constant and the first region comprises a first dopant;
forming a second region of the Zener diode in contact with the first region, wherein the second region has a second dopant;
wherein the first dopant and the second dopant are different types of carrier providing dopants, and a lattice mismatch between the first lattice constant is selected to produce compressive stress in a junction region between the first region and the second region in a direction of current flow.

The region of the Zener diode with the first lattice constant may comprise or be formed from silicon germanium.

The Zener diode of the first aspect may include any of the features of the third aspect and any of the features of the first or second aspect.

These and other aspects of the invention will be apparent from, and elucidated with reference to, the embodiments described hereinafter.

### Brief description of Drawings

Embodiments will be described, by way of example only, with reference to the drawings, in which:
Figure 1 is a schematic drawing of an example Zener diode;
Figure 2 is a schematic drawing of a bending test arrangement for checking a strain sensitivity of a Zener diode breakdown voltage, showing: a) the application of tensile stress in the direction of current flow at the junction, and b) the application of compressive stress in the direction of current flow at the junction;
Figure 3 is a plot showing a change of breakdown voltage during a bending test in which tensile stress is imparted at the junction in the direction of current flow;
Figure 4 is a plot showing a change of breakdown voltage during a bending test in which compressive stress is imparted at the junction in the direction of current flow;
Figure 5 is a plot showing simulations of a shift in Zener breakdown voltage with respect to stress at the junction in the direction of current flow, including test results obtained from experiments as illustrated in Figure 2;
Figure 6 illustrates an example method for making a Zener diode; and
Figure 7 is a further example of a Zener diode.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar feature in modified and different embodiments.

### Detailed description of embodiments

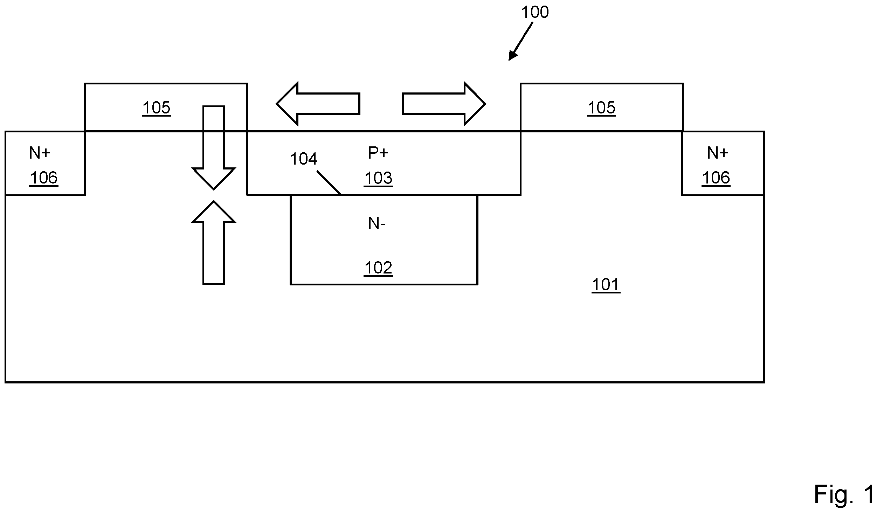

Figure 1 shows an example Zener diode 100. The Zener diode 100 comprises a first region 102 (in this example an N doped semiconductor region or N well) in contact with a second region 103 (in this example a P doped semiconductor region or P well). The interface between the first region 102 and the second region 103 defines a junction 104. The Zener diode 100 further comprises a substrate 101 (in this example, N doped), contact region 106 (in this example, N doped), and dielectric layer 105. The N well and P well comprise crystalline silicon.

The dielectric layer 105 in this example comprises silicon nitride, but other suitable dielectric layers can equally be used (e.g. silicon oxide). Electrical contacts may be made (e.g. by deposition of further patterned metal layers) to the N doped contact region 106 and to the P well 103. The electrical contact established at the contact region 106 can be used to apply an electrical voltage on one side of the junction 104 via the substrate 101 and the first region 102. The electrical contact at the second region 102 can be used to apply an electrical voltage to the other side of the junction 104. In use, the Zener diode is typically reverse biased and operated with a more negative voltage on the P well (in this example, the second region 103) relative to the N well (in this example, the first region 102). When the voltage difference across the junction 104 exceeds the breakdown voltage, current will flow. When the voltage difference across the junction is below the breakdown voltage, current will not flow (or very little current will flow).

Current flow through the Zener diode 100, in use, is perpendicular to the plane of the junction 104 (in the vertical direction, relative to the orientation of Figure 1).

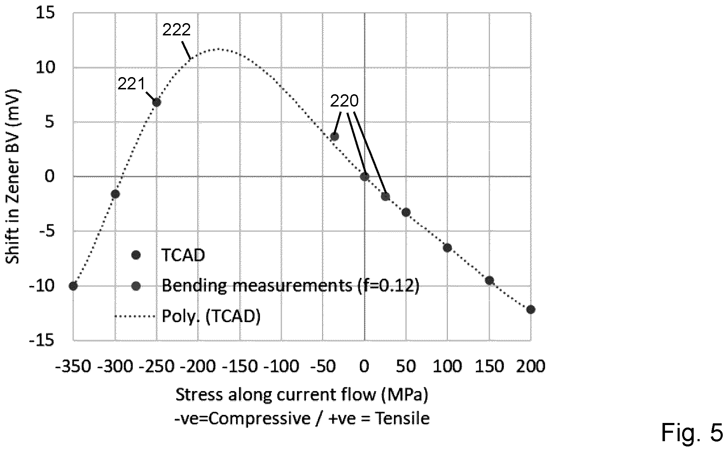

The second region 103 is formed with an intrinsic biaxial in-plane tensile stress. An in-plane tensile stress results in a compressive stress in the direction of current flow (normal to the plane of the layer second region 103). The compressive stress is selected to reduce a sensitivity of the breakdown voltage of the junction 104 with respect to stresses that may be imposed on the packaged Zener diode 100 during use. As will be explained more clearly with reference to Figure 5, the relationship between breakdown voltage and stress is not linear, and there are some ranges of values of stress in which a sensitivity of the junction breakdown voltage to changes in stress is relatively low. With careful engineering of the Zener diode, an intrinsic stress may be provided at the junction 104 that mitigates a sensitivity of the breakdown voltage to stress. More stable Zener diodes may enable more stable voltage references, or simpler designs for voltage references that meet specific performance criteria.

One suitable way to cause an appropriate amount of stress at the junction 104 is to grow a second region 103 that has a lattice mismatch with the underlying first region 102. In some examples, the second region 103 (in this example, the P well) may be doped to adjust its lattice constant and the lattice constant of the first region 102 (in this example the N well) may have a lattice constant corresponding with normal doped silicon (e.g. the same as the intrinsic lattice constant, or within 0.05% thereof). In other examples it may be the first region 102 that has an adjusted lattice constant and the second region 103 that has a lattice constant corresponding with that of normal doped silicon (e.g. within 0.05%).

For example, the first region 102 may comprise crystalline silicon that is doped with phosphorous, and having a lattice constant equal to that of intrinsic silicon. The second region 103 may be epitaxially grown crystalline silicon with a dopant (which may be referred to as a stress control dopant) that affects the lattice constant of the second region 103, thereby producing a lattice mismatch between the second region 103 and the first region 102, resulting in a stress at the junction 104. The stress control dopant preferably does not donate carriers or affect the electronic properties of the material it is doping.

A suitable stress control dopant is carbon, which has a smaller atomic radius than silicon, and therefore reduces the lattice constant of silicon as a result of its incorporation. A 1 mol% carbon doping results in biaxial in-plane stress of approximately +600 MPa (i.e. tensile), and a 3 mol% carbon doping results in biaxial in-plane stress of approximately +2 GPa. The resulting stresses normal to the plane due to Poisson contraction are approximately -200 Mpa and -600 MPa respectively. The relationship between doping concentration and the resulting stress is roughly linear, so approximate values of stress can be obtained by interpolation between these values, and a suitable process for achieving a particular desired stress can be achieved by experimentation. As will be explained more fully below with reference to Figure 5, a suitable value of compressive stress in the junction may be 200MPa (or somewhere near that value). Suitable ranges for carbon concentration may be: between 0.5 mol% and 2 mol%. Suitable stress ranges at the junction 104 in the direction of current flow may be between -225 MPa and -125 MPa or more particularly between - 200 MPa and -150 MPa.

Although Figure 1 shows an example in which the P well is the second region, this is not essential, and the doping types can be reversed so that each region that is described as N doped is instead P doped, and each region that is described as P doped is instead N doped. The amount of carbon dopant in the second region and/or the accompanying stress states may be the same as described with reference to the dopant types that are shown in Figure 1.

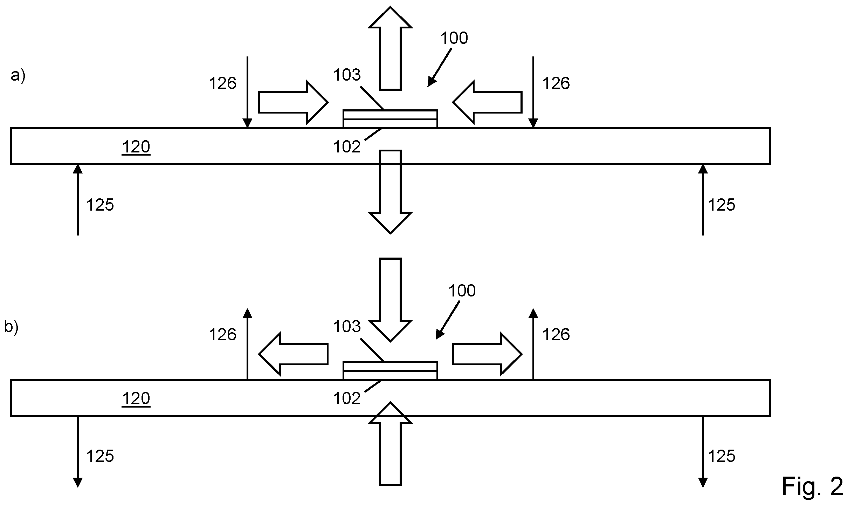

Figure 2 schematically illustrates a test arrangement for investigating a sensitivity to strain of a Zener diode 100. In the test arrangement, the Zener diode 100 is bonded to a beam 120. For simplicity, the Zener diode 100 is illustrated as only comprising second region 103 and first region 102, forming a junction therebetween. The beam 120 is simply supported and loaded with a pure bending moment via four spaced apart support points 125, 126.

In Figure 2a), an upward force is applied to each outer support point 125 and an equal downward force is applied at each inner support point 126. The result is compression of the upper surface of the beam 120, and therefore in-plane compressive stress on the Zener diode 100 and tensile stress at the junction between the first region 102 and the second region 103 in the direction of current flow.

In Figure 2b), a downward force is applied to each outer support point 125 and an equal upward force is applied at each inner support point 126. The result is tension of the upper surface of the beam 120, and therefore in-plane tensile stress on the Zener diode 100 and compressive stress at the junction in the direction of current flow.

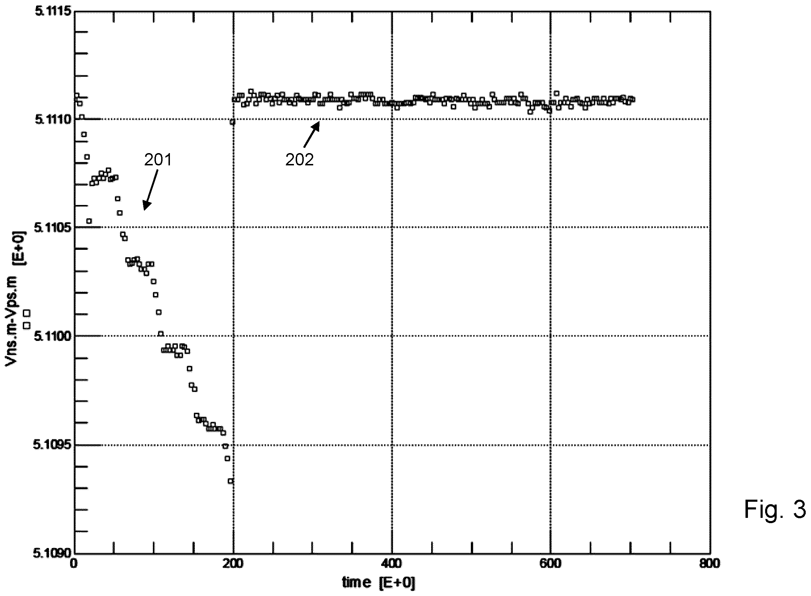

Figure 3 shows measured breakdown voltage values 201 with respect to time during a bending test as shown in Figure 2a), with tensile stress at the junction in the direction of current flow. After the bending moment is removed, the breakdown voltage values 202 return to a baseline level. The bending stress at the top layer of the beam in this experiment at the maximum was -212 MPa. Assuming the materials are elastic (i.e. linear) the stress in the junction will follow a linear relationship with the stress at the beam surface. The stress in the junction in the direction of current flow *σ_{f}* can related to stress at the beam surface *σ* by the equation *σⱼ = σ.f,* where *f* is a constant of proportionality associated with the Zener diode. The experiment shows that the breakdown voltage of the Zener diode reduces in response to the tensile stress in the direction of current flow at the junction.

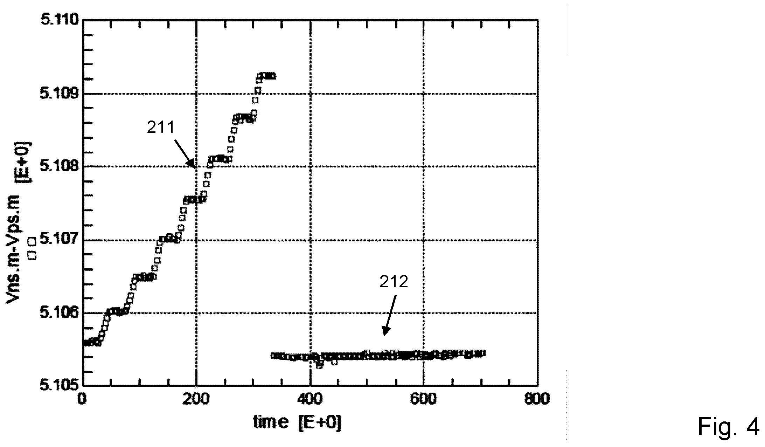

Figure 4 shows measured breakdown voltage values 211 with respect to time during a bending test as shown in Figure 2b), with compressive stress at the junction in the direction of current flow. After the bending moment is removed, the breakdown voltage values 212 return to a baseline level. The bending stress at the top layer of the beam in this experiment at the maximum was +300MPa. A change in breakdown voltage of +3.7mV resulted from the maximum bending stress.

Repeated experiments like those shown in Figure 3 and 4 can be performed. The results can be compared to computer simulations based on the underlying semiconductor physics. The value of *f* can be determined as the value that produces the best fit in such a comparison.

Figure 5 shows a simulated variation in breakdown voltage with respect to stress at the junction in the direction of current flow for a Zener diode. Data points obtained from experiment 220 are each labelled. Data points 220 are obtained from bending experiments as described with reference to Figures 2, 3 and 4, and are plotted based on a value for *f* of 0.12. The other data points 221 are all obtained by simulation. A polynomial fit 222 to the data points 220, 221 is shown. The data of Figure 5 indicate that there is a region of stress values (at the junction, in the direction of current flow) of between -200 MPa and -150 MPa over which the sensitivity of the breakdown voltage to stress is relatively low.

This finding is consistent with semiconductor physics. The below equation describes a carrier tunnelling probability Θ: $Θ = exp \left(-\frac{4}{3}\frac{\sqrt{2 m *}}{ℏq}\frac{{E}_{g}^{\frac{3}{2}}}{ε}\right)$

Where *m** is the effective mass of carriers; *E_{g}* is the bandgap energy of the semiconductor; *ε* is the electric field across the junction; *q* is the elementary charge; ℏ is the reduced Planck's constant. Strain (which is proportional to stress in a linear material) modifies the bandgap through deformation of the lattice. Tensile strain reduces the bandgap and compressive strain increases the bandgap. The tunnelling probability depends on ${E}_{g}^{\frac{3}{2}}$, so small changes in bandgap can have a significant effect on tunnelling probability and hence breakdown voltage. Strain also affects the effective mass of carriers (electrons and holes) due to modifications of the conduction and valence band structures. Tensile strain typically reduces effective mass, enhancing tunnelling. Compressive strain increases effective mass, reducing tunnelling. There therefore is the potential for a crossover point under compressive stress at which these effects balance, and at this crossover value of compressive stress the Zener diode is insensitive to stress, as depicted by the polynomial fit 222 in Figure 5.

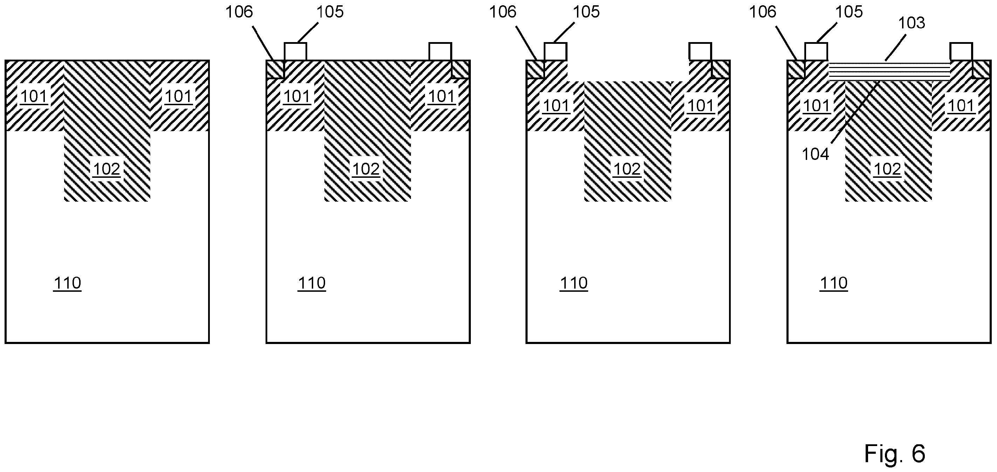

Figure 6 illustrates a further example method by which a Zener diode can be produced in which stress in induced by a lattice mismatch. Four stages in the process are depicted. The method starts with a P doped crystalline silicon layer 110. An first n doped region 102 forming an N-well is defined with a shallow heavy implant and a deep implant. Example implant dosage and energy for the shallow heavy implant and the deep implant are, respectively: phosphorous, 500keV, 10¹⁵/cm² and phosphorous, 2000keV, 10¹³/cm². A more lightly N doped region 101 is defined to provide an electrical link from the N-well region 102 to a device cathode. The doped regions 101, 102 may be defined in the normal way, using a lithographically patterned soft mask (comprising resist) and/or a hard mask (defined in a material such as silicon oxide or silicon nitride).

A dielectric layer 105 (e.g. silicon nitride or silicon oxide) is deposited and patterned (e.g. with a lithographic process and an etch) to demarcate heavily doped P-type and N-type regions. A heavily doped N-type region 106 is defined to provide a region for ohmic contact to a metal cathode. An etched region is formed by etching, at least partially masked by the dielectric layer. A second doped crystalline silicon region 103 is re-grown in the etched region (e.g. by vapour phase epitaxy). The doped crystalline silicon region 103 may comprise silicon that is doped with: boron to a concentration of between 10¹⁸ cm⁻³ and 10²⁰cm⁻³; and carbon to between 0.5 mol% and 2 mol%. The lattice mismatch between the second region 103 and the first region 102 results in a tensile in-plane stress in the second region 103, which imparts a compressive stress in the direction of current flow at the junction 104 between the first region 102 and the second region 103.

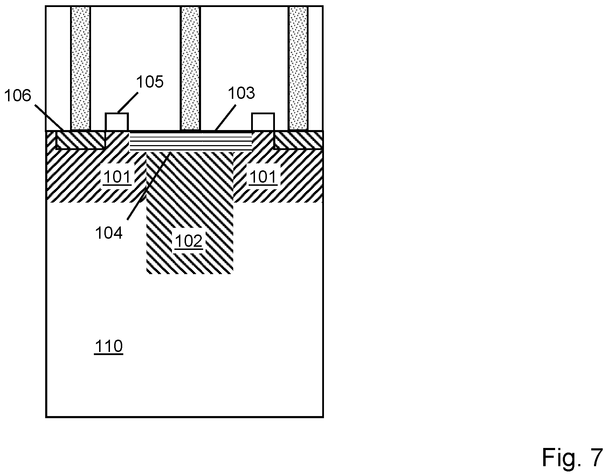

Figure 7 shows a further stage in an example method of making a Zener diode, in which electrical connections (e.g. metal traces comprising gold, copper, aluminium etc) are made to the heavily doped n-type region 106 and to the second region 103. The electrical connections may connect the Zener diode to other elements of an integrated circuit.

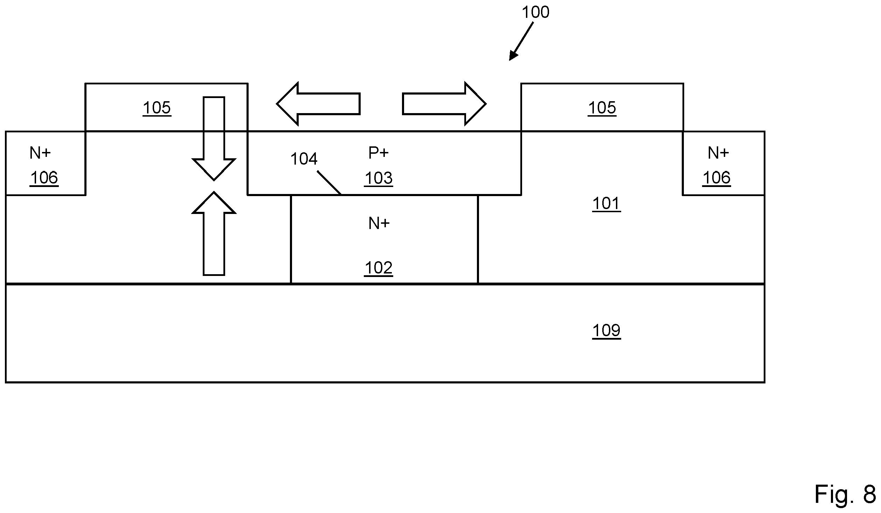

Figure 8 illustrates an alternative approach to achieving a strain insensitive Zener diode in which lattice mismatch is used to cause a compressive stress in the junction in the direction of current flow. The Zener diode 100 has similar features to the Zener diode described with reference to Figure 1, and the description of that example is applicable to this example, except that there is no lattice mismatch between the first region 102 and the second region 103, and the second region is not doped with a stress control dopant. The Zener diode 100 comprises a crystalline SiGe layer 109, which has a lattice mismatch with the first region 102. The first region 102 is consequently placed under in-plane tensile stress, which will result in the junction 104 being placed under compressive stress in a direction of current flow.

Germanium has a higher atomic radius than silicon. The effect on lattice constant of Ge can be expected to be about 5 times lower in magnitude than that of C, and in the other direction. Around 5% Ge might be expected to produce a similar lattice mismatch as 1% C (in the opposite direction).

An advantage of the method and device disclosed herein is that a Zener diode can be produced that has a more stable or consistent breakdown voltage. More specifically, a Zener diode can be produced that has a breakdown voltage that is relatively insensitive to stress. Stress may be result from manufacturing and packaging, or may be experienced in use. In the case of manufacturing induced stresses, the intrinsically lower sensitivity to these stresses may result in devices with a lower statistical variation in breakdown voltage. In the case of "in-use" stress, Zener diodes with lower stress sensitivity are less prone to variations in their breakdown voltage in use. Such Zener diodes may be very useful in the context of voltage regulation, and precision voltage regulation.

From reading the present disclosure, other variations and modifications will be apparent to the skilled person. Such variations and modifications may involve equivalent and other features which are already known in the art of automated speech recognition systems, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A Zener diode(100) comprising:
a first region (102) comprising a first dopant:
a second region (103) with a second dopant in contact with the first region (102), the first region (102) and second region (103) defining a junction (104) of the Zener diode (100) at an interface between the first region (102) and the second region (103);
wherein:
i) the first dopant and the second dopant are different types of carrier-providing dopants; and
ii) the junction (104) comprises a compressive stress in a direction of current flow through the junction (104) resulting from a lattice mismatch between: a) the first region (102) and the second region (103); or b) the first region (102) and another region of the Zener diode (100).

2. The Zener diode (100) of claim 1, wherein the lattice mismatch is between the first region (102) and the second region (103), and the second region (103) comprises 0.5 mol% to 2 mol% carbon doping, and the first region (102) has a lattice constant equal to that of intrinsic silicon.

3. The Zener diode (100) of claim 1 or 2, wherein the compressive stress is between 100 MPa and 250 MPa.

4. The Zener diode (100) of any preceding claim, wherein the compressive stress is between 150 MPa and 200 MPa.

5. The Zener diode (100) of any preceding claim, wherein the first region (102) has a dopant concentration of the first dopant in the range 10¹⁷cm⁻³ to 10¹⁹cm⁻³ and/or wherein the second region (103) has a dopant concentration of the second dopant in the range 10¹⁸cm⁻³ to 10²¹cm⁻³.

6. The Zener diode (100) of any preceding claim wherein the lattice mismatch is between the first region (102) and another region (109) of the diode (100), and wherein the first region (102) comprises a lattice constant equal to that of intrinsic silicon and the other region (109) comprises silicon germanium.

7. The Zener diode (100) of any preceding claim, wherein: i) the first dopant is n-type and the second dopant is p-type; or ii) the first dopant is p-type and the second dopant is n-type.

8. The Zener diode (100) of any preceding claim, wherein the first region and the second region are formed from crystalline silicon.

9. A voltage regulator comprising the Zener diode (100) of any preceding claim.

10. A method of making a Zener diode (100), comprising:
implanting a first region (102) of crystalline silicon with a first dopant;
etching a portion of the first region (102),
depositing a doped crystalline silicon into the etched portion to define a second region (103) and a junction (104) between the first region (102) and the second region (103);
wherein: the doped crystalline silicon of the second region (103) comprises a second dopant; the first dopant and the second dopant are different types of carrier-providing dopants; and the junction (104) comprises a compressive stress in a direction of current flow through the junction resulting from a lattice mismatch between the first region (102) and the second region (103).

11. The method of claim 10, wherein the second region (103) comprises between 0.5 mol% and 2 mol% carbon doping.

12. The method of claim 10 or 11, wherein the compressive stress is between 100 MPa and 250 MPa.

13. The method of any of claims 10 to 12, wherein the compressive stress is between 150 MPa and 200 MPa.

14. The method of any of claims 10 to 13, wherein the first region (102) has a dopant concentration of the first dopant in the range 10¹⁷cm⁻³ to 10¹⁹cm⁻³ and/or wherein the second region (103) has a dopant concentration of the second dopant in the range 10¹³cm⁻³ to 10²¹cm⁻³.

15. The method any of claim 10 to 14, wherein: i) the first dopant is n-type and the second dopant is p-type; or ii) the first dopant is p-type and the second dopant is n-type.
